Europäisches Patentamt

(19) European Patent Office

Office européen des brevets

(11) EP 0 819 782 A1

(12) EUROPEAN PATENT APPLICATION

(43) Date of publication:
21.01.1998 Bulletin 1998/04

(51) Int. Cl.6: C30B 13/24

(21) Application number: 97112059.7

(22) Date of filing: 15.07.1997

(84) Designated Contracting States:
AT BE CH DE DK ES FI FR GB GR IE IT LI LU MC
NL PT SE

(30) Priority: 16.07.1996 JP 186258/96

(71) Applicant:
TOYOTA JIDOSHA KABUSHIKI KAISHA
Aichi (JP)

(72) Inventors:
• Nakamura, Naoki
Toyota-shi, Aichi-ken, 471 (JP)

• Hasegawa, Hiroshi
Toyota-shi, Aichi-ken, 471 (JP)
• Hanabusa, Mitsugu
Toyohashi-shi, Aichi (JP)

(74) Representative:
Tiedtke, Harro, Dipl.-Ing. et al
Patentanwaltsbüro
Tiedtke-Bühling-Kinne & Partner
Bavariaring 4
80336 München (DE)

(54) Process of forming a thin film by laser ablation

(57) A process of forming a crystal thin film by laser ablation, comprising the step of: either performing plural times a deposition and recrystallization cycle composed of the phase of irradiating a laser beam (1) to a target (8) to cause emission of a material (14) from the target and deposition of the emitted material on a substrate (5) and the phase of irradiating a laser beam (12) to a deposited layer formed by said deposition to cause melting and recrystallization of the deposited layer, thereby forming a crystal thin film having a selected thickness; or performing at least once a deposition and recrystallization cycle composed of the phase of irradiating a laser beam (1) to a target to cause emission of a material (14) from the target and deposition of the emitted material on a substrate (5) and the phase of irradiating a laser beam (12) to a deposited layer formed by said deposition to cause melting and recrystallization of the deposited layer; and then performing said phase of deposition alone to cause an epitaxial growth on a crystal layer formed by said melting and recrystallization, thereby forming a crystal thin film having a selected thickness.

Fig.1

EP 0 819 782 A1

## Description

BACKGROUND OF THE INVENTION

1. Field of the Invention

The present invention relates to a process of forming a crystal thin film by laser ablation.

2. Description of the Related Art

A process of forming a thin film by laser ablation, which includes irradiating a laser beam to a target to cause emission of a material from the target and depositing the emitted material on a substrate to form a thin film, is known.

Laser ablation is advantageous because:

1) A high purity thin film containing very small amounts of impurities is obtained because the film is only made of atoms, molecules, and ions emitted from a target in a vacuum chamber;
2) An optimum film forming condition for a desired thin film can be freely selected because many parameters including the atmosphere pressure, the substrate temperature, the film growth speed can be separately set; and
3) The film forming cost is reduced because the film growth speed is high and the film growth process is simple.

Laser ablation is drawing attention as a process for producing a high quality silicon thin film to realize low cost, high efficiency thin film solar cells, thin film transistors (TFT), and other optoelectronic devices on commercial base. Many studies are also conducted for the laser ablation to grow diamond-like carbon thin films, high temperature superconductor films, and dielectric thin films.

Laser ablation, however, has a problem that the material emitted from a target does not only contain atoms, molecules and ions but also contains undissociated particles or clusters, which enter the thin film. Moreover, there is also a problem that the retained oxygen in a high vacuum enters the thin film. For example, when a silicon thin film is used in an optoelectronic device, particles present in the thin film are detrimental to the device functions or oxygen contained in the thin film also has an adverse effect on the basic physical properties of semiconductor such as electric properties (resistivity, etc.) and optical properties (light absorption, etc.).

To prevent particles from entering the thin film, Japanese Unexamined Patent Publication (Kokai) No. 5-279848, for example, proposed a method to suppress the entrance of particles by irradiating another laser beam to the emitted material from a target to dissociate clusters in the emitted material.

Other proposals include: introducing ions alone by using a fan-shaped electrostatic electrode (Japanese Unexamined Patent Publication (Kokai) No. 5-247633); using a pair of flat electrodes located between a target and a substrate holder to adsorb charged-up particles at the electrodes (Japanese Unexamined Patent Publication (Kokai) No. 5-279844); irradiating a laser beam through a magnetic gap between a pair of permanent magnets to prevent entrance of droplets (Japanese Unexamined Patent Publication (Kokai) No. 4-362171); disposing a pair of mirrors beside a target to cause multiple reflection of a laser beam for dissociating particles, thereby vaporizing droplets (Japanese Unexamined Patent Publication (Kokai) No. 5-44022); disposing an electrode between a target and a substrate to generate a plasma synchronously with irradiation of a laser beam (Japanese Unexamined Patent Publication (Kokai) No. 3-164407); disposing an electroconductive hollow cylinder between a target and a substrate to generate a plasma (Japanese Unexamined Patent Publication (Kokai) No. 4-219302); etc.

To prevent entrance of oxygen, the present applicant proposed introduction of silane gas (Japanese Unexamined Patent Publication (Kokai) No. 8-8644) and ion beam assistance (Japanese Unexamined Patent Publication (Kokai) No. 8-8619).

Although the above-recited proposals effectively prevent entrance of particles and oxygen, difficulty remains in forming a crystalline thin film, particularly heteroepitaxial growth of a crystalline thin film on a substrate of a different material and low temperature growth of a crystalline thin film.

On the other hand, a melt-recrystallization process by laser irradiation is also known. For example, reports submitted in the 1994 Spring Combined Cross Lecture Meeting of Applied Physics include "The Surface Nature and TFT properties of Excimer Laser-Crystallized Poly-Si Film" (Semiconductor Energy Laboratory), "A Retained Stress of Poly-Si Thin Film by Excimer Laser Annealing" (NEC Functional Energy Laboratory), "Conversion of a-Si Thin Film to Poly-Si by Excimer Laser Anneal" (Tokyo Electron), etc. Japanese Unexamined Patent Publication (Kokai) No. 6-188190 and Japanese Unexamined Patent Publication (Kokai) No. 3-248574 also disclosed a laser melt-recrystallization process. The term "melt-recrystallization" means that an amorphous phase is melted and solidified to form a crystalline phase.

The above-recited processes were conventionally utilized so that a laser beam is irradiated onto an amorphous deposited film to cause melt-recrystallization to form a crystal thin film.

However, the conventional process of irradiating a laser beam onto a deposited film having a desired thickness to cause melt-recrystallization has the following problems:

(1) Crystal thin films for the above-mentioned application must have a thickness of from several hundreds nm to several tens of µm. However, it is difficult to recrystallize a deposited film having such a thickness uniformly over the thickness to provide a polycrystalline thin film having large grains necessary for that application.

(2) Cracks or other defects frequently occur in the thin film due to difference in thermal expansion during melt-recrystallization.

(3) Recrystallization through the film thickness to the vicinity of the interface with the substrate requires a laser irradiation with high energy density, causing ablation of the deposited film.

(4) The grain size is generally increased with an increase in the irradiated laser shots, but when the film thickness is more than 100 nm, the grain size increasing effect by the shot number increase disappears.

SUMMARY OF THE INVENTION

The object of the present invention is to provide a process of forming a crystal thin film by laser ablation, which enables uniform recrystallization over the film thickness, without causing cracks or other defects to occur during melt-recrystallization.

To achieve the object according to the first invention, there is provided a process of forming a crystal thin film by laser ablation, comprising the step of:

performing plural times a deposition and recrystallization cycle composed of the phase of irradiating a laser beam to a target to cause emission of a material from the target and deposition of the emitted material on a substrate and the phase of irradiating a laser beam to a deposited layer formed by said deposition to cause melting and recrystallization of the deposited layer, thereby forming a crystal thin film having a selected thickness.

According to the first invention, the deposition and recrystallization cycle is repeated to finally provide a crystal thin film having a desired thickness. In this process, melt-recrystallization can be carried out with a deposited film having an extremely small thickness, typically of an atomic order thickness, so that the deposited film can be recrystallized over the entire thickness to form a uniform crystal thin film having a desired thickness and large grains while preventing occurrence of cracking due to difference in thermal expansion.

To achieve the above object according to the second invention, there is also provided a process of forming a crystal thin film by laser ablation, comprising the steps of:

performing at least once a deposition and recrystallization cycle composed of the phase of irradiating a laser beam to a target to cause emission of a material from the target and deposition of the emitted material on a substrate and the phase of irradiating a laser beam to a deposited layer formed by said deposition to cause melting and recrystallization of the deposited layer; and

then performing said phase of deposition alone to cause an epitaxial growth on a crystal layer formed by said melting and recrystallization, thereby forming a crystal thin film having a selected thickness.

According to the second invention, the deposition and recrystallization cycle is performed at least once to form a very thin initial crystal layer on a substrate and the deposition alone is then performed to cause epitaxial growth to occur on the initial crystal layer to finally provide a crystal thin film having a desired thickness. In this process, melt-recrystallization is performed with a deposited film having a very small thickness as in the first invention to ensure complete recrystallization over the entire film thickness without the occurrence of cracks or other defects due to difference in thermal expansion, and deposition alone is then performed on the thus-formed crystal layer to cause epitaxial growth to occur, thereby finally providing a uniform crystal thin film having a desired thickness and large grains. The substrate may be held at a temperature suitable to epitaxial growth, such as 500°C.

According to the present invention, melt-recrystallization of a deposited layer can be performed at an atomic thickness order by irradiating a laser beam not only to a target but also to a substrate, so that melt-recrystallization is completely effected to form a polycrystalline thin film having large grains. The present invention thus advantageously provides a polycrystalline thin film having large grains even for a heteroepitaxial crystal thin film, which was extremely difficult to form by the conventional process of forming a thin film by laser ablation.

It is also advantageous that the production process is simplified and has an improved efficiency because of parallel progress of deposition and crystallization. Specifically, according to the first invention, deposition and melt-recrystallization processes are alternately repeated to effect substantially simultaneous progress of both processes. In the second invention, deposition and melt-recrystallization processes are substantially simultaneously effected in the initial cycle, and in the subsequent process, deposition alone is simply performed to cause epitaxial growth process to occur, in which deposition and crystallization literally proceed simultaneously.

A further advantage is obtained in that the entrance of particles into a thin film is also prevented because the laser beam irradiated to a deposited layer on a substrate also effectively acts for dissociation of particles stuck to the substrate or the deposited layer and particles in the emitted material from a target.

An embodiment of the present invention includes branching a laser beam through a light branching means such as a half-mirror and a beam-splitter to form two laser beams, using one of the two laser beams as a laser beam to be irradiated to a target for laser ablation and using the other as a laser beam to be irradiated to a substrate for melt-recrystallization. This minimizes the number of laser source to one and reduces the production cost.

BRIEF DESCRIPTION OF THE DRAWINGS

Figure 1 is a cross-sectional view showing an apparatus for forming a crystal thin film using separate laser beams for laser ablation and melt-recrystallization according to the present invention;
Fig. 2 is a schematic perspective view of a preferred arrangement for irradiating a laser beam for melt-recrystallization according to the present invention;
Figs. 3(a) and 3(b) are typical time charts of laser pulses for use in the present invention;
Figs. 4(1) to 4(4) are cross-sectional views schematically showing process steps for forming a crystal thin film according to the present invention;
Fig. 5 is a graph showing a Raman scattering spectrum of a silicon crystal thin film formed by a process according to the present invention;
Fig. 6 is a cross-sectional view of an arrangement for branching a laser beam in a process of forming a crystal thin film by laser ablation according to the present invention;
Fig. 7 is a time chart of deposition and melt-recrystallization in an arrangement shown in Fig. 6; and
Fig. 8 is a cross-sectional view of another arrangement for branching a laser beam in a process of forming a crystal thin film by laser ablation according to the present invention.

DESCRIPTION OF THE PREFERRED EMBODIMENTS

Example 1

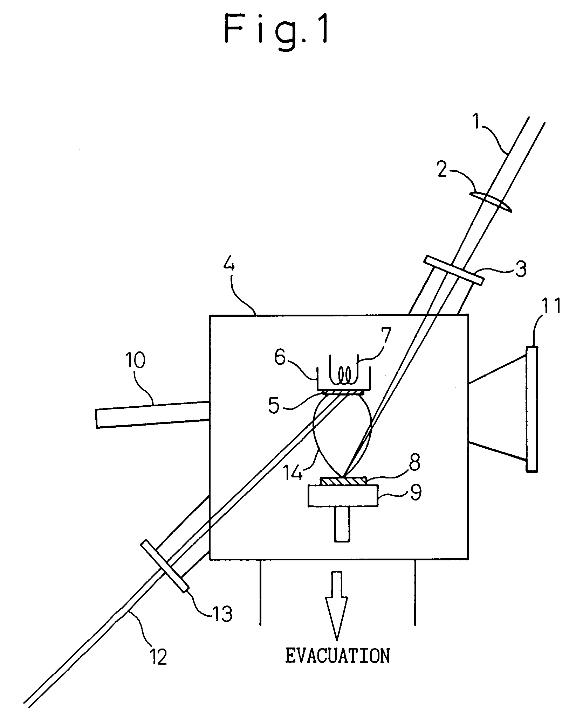

Figure 1 shows an apparatus for forming a crystal thin film by laser ablation according to an embodiment of the present invention. A vacuum chamber 4 contains a substrate 5 and a target 8. A substrate holder 6 is equipped with a heater 7 therein to control the temperature of the substrate 5. The target 8 is held on a target holder 9. A laser beam 1 (the first laser beam) for laser ablation is directed through a lens 2 and a laser beam introduction port 3 into the vacuum chamber 4 and irradiated to the target 8. The irradiation causes emission from the target 8 and the emitted material forms a plume 14, which reaches the substrate 5 to form a deposited layer on the substrate 5.

Another laser beam 12 (the second laser beam) is introduced into the vacuum chamber 4 through another laser beam introduction port 13 and is irradiated to the deposited layer on the substrate 5.

To examine the crystal quality of a crystal thin film formed on the substrate 5, the vacuum chamber is also equipped with RHEED (reflection high energy electron diffraction) units 10 and 11.

A silicon wafer and a synthetic quartz substrate were used as the substrate 5 in this example. The first laser beam 1 for laser ablation was ArF excimer laser having a wave length of 193 nm or KrF excimer laser having a wavelength of 248 nm, which were irradiated at an irradiation energy of from 15 to 80 mJ/pulse. A vacuum of $5 \times 10^{-7}$ Torr was maintained in the vacuum chamber 4. The second laser beam 12 for melt-recrystallization was a YAG laser having a wavelength of 1064 nm or an ArF laser having a wavelength of 193 nm.

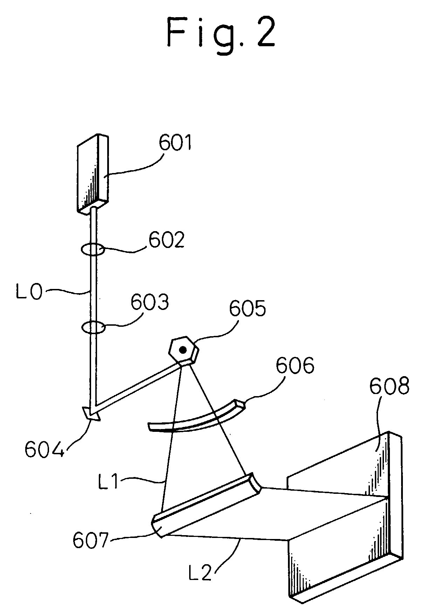

Figure 2 shows a preferred embodiment of an irradiation system of the second laser beam for melt-recrystallization advantageously applicable to the process according to the present invention. In the shown system, a laser beam can be scanned for uniform melt-recrystallization over a wide area.

A laser beam L0 irradiated from a laser source 601 proceeds through a collimator lens 602 and a cylindrical lens 603 and is directed to a polygonal mirror 605 by a reflection mirror 604. The polygonal mirror 605 is rotated to provide a radially scanned laser beam L1, which proceeds through an fθ lens 606 and a cylindrical lens 607 and is irradiated onto a substrate 608.

Referring to Fig. 1, a process of forming a crystal thin film according to the first invention is performed in the following sequence. The first laser beam is irradiated to the target 8 for a short time. This vaporizes or ionizes the material of the target 8 and the emitted material from the target 8 forms a plume 14, which reaches the substrate 5. Deposition occurs on the substrate 5 for a short time corresponding to the short time irradiation to form a thin deposited layer on the substrate 5, the layer ultimately having an atomic order thickness. Immediately thereafter, the second laser beam 12 for melt-recrystallization is irradiated to the deposited layer to melt-recrystallize the deposited layer. The deposition and melt-recrystallization cycle is repeated to finally provide a crystal thin layer having a desired thickness. Namely, the first laser beam is irradiated to form a primary deposited layer, the second laser beam is irradiated to melt-recrystallize the primary deposited layer, the first laser beam is irradiated to form a second deposited layer, and the second laser beam is irradiated to melt-recrystallize the second deposited layer, and so on, to form a crystal thin film having a desired thickness.

In this process, the second and subsequent layers are easily crystallized because deposition occurs on a crystallized layer.

The second invention utilizes this fact in such a manner that the primary or additional several layers are crystallized to establish a stable crystal layer, on which deposition alone is then performed to grow an epitaxial layer, thereby finally providing a crystal thin film having a desired thickness.

Generally, the process according to the first invention is suitably used when the substrate temperature is room temperature, and when the substrate is held at higher temperatures which facilitate epitaxial growth (e.g., about 500°C for epitaxial growth of silicon crystal), the process according to the second invention is more advantageously used to simplify the film forming process.

The first laser beam for laser ablation and the second laser beam for melt-recrystallization may be a continuous laser or a pulse laser, although pulse lasers advantageously provide greater irradiation energies. The energy and irradiation time of the first laser beam influences the thickness of the deposited layer (or the crystallized layer obtained by deposition and melt-recrystallization) and the energy and irradiation time of the second laser beam influences the crystallized degree achieved by melt-recrystallization.

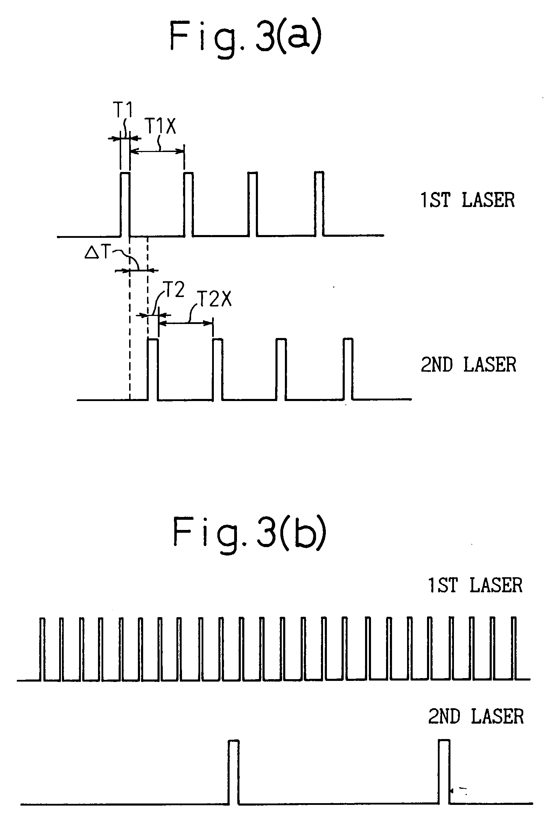

Figures 3(a) and 3(b) show two typical time charts for laser pulses when pulse lasers are used as the first laser beam for ablation and the second laser beam for melt-recrystallization.

In the example shown in Fig. 3(a), the first and second laser beams have the same frequency, and one shot of the first laser pulses corresponds to one shot of the second laser pulse. Specifically, one shot of the first laser beam forms a deposited layer and one shot of the second laser beam then irradiates the deposited layer to melt-recrystallize the deposited layer. Referring to Fig. 3(a), the first and second laser beam have pulse-oscillating periods of $T1$ and $T2$ and non-pulse-oscillating periods of $T1X$ and $T2X$, respectively.

$\Delta T$ is an oscillation time difference of the second laser beam with respect to the first laser beam and has a value such that melt-recrystallization is effected after completion of formation of the deposited layer in one deposition and melt-recrystallization cycle. This is because, referring to Fig. 1, it takes a time corresponding to the distance between the target 8 and the substrate 5 for the plume 14 of the material emitted from the target 8 by irradiation of the first laser beam 1 to reach the substrate 5.

Suppose that a delay time $\Delta D1$ is a time difference from a pulse termination time of the first laser beam 1 to the time at which the emitted material reaches the substrate 5 and that a deposition time $\Delta D2$ is a time elapsed from the beginning of deposition by that pulse to the substantial completion of the deposition, a time $\Delta D$ (hereinafter referred to as "a deposition time lag") elapsed until the termination of the first shot of the first laser beam to is expressed as $\Delta D = \Delta D1 + \Delta D2$.

To ensure that melt-recrystallization is effected after completion of the formation of a deposited layer by one cycle, the oscillation time difference $\Delta T$ between the first laser beam and the second laser beam must be greater than the deposition time lag $\Delta D$.

The oscillation periods $T1$ and $T2$ have fixed values which are characteristic to the laser used whereas the non-oscillating periods $T1X$ and $T2X$ are variable by varying the oscillating frequency. This enables $\Delta T$ to be set at a suitable value.

In the example shown in Fig. 3(b), the first laser beam has an oscillating frequency ten times greater than that of the second laser beam, so that ten shots of the oscillation pulses of the first laser beam correspond to one shot of the oscillation pulse of the second laser beam. This means that ten shots of oscillation pulses of the first laser beam form a deposited layer, which is then melt-recrystallized by one shot of oscillation pulse of the second laser beam. In this case, one deposition and melt-recrystallization cycle is composed of the phase of deposition by ten oscillation or irradiation shots of the first laser beam and the phase of melt-recrystallization by one oscillation or irradiation shot of the second laser beam. Generally, one deposition and melt-recrystallization cycle may be composed of plural shots of irradiation of a laser beam for ablation and one shot of irradiation of a laser beam for melt-recrystallization, so long as uniform melt-recrystallization is ensured without occurrence of cracks or other defects.

This simplifies, and improves the efficiency of, the production process, because the number of shots of the second laser beam for melt-recrystallization can be reduced although the irradiation time per shot is increased in accordance with the thickness of the deposited layer, and because the deposition time can be reduced by increasing the frequency of the first laser beam for ablation.

In this example, a first laser beam for laser ablation having a frequency of 10 Hz was irradiated with an irradiation energy density of 30 $J/cm^2$ to provide a growth rate of 1.7 nm/min and a second laser beam for melt-recrystallization was irradiated with an irradiation energy of 0.5 $J/cm^2$ at every 30 min ($T1 + T2$) of the irradiation time of the first laser beam.

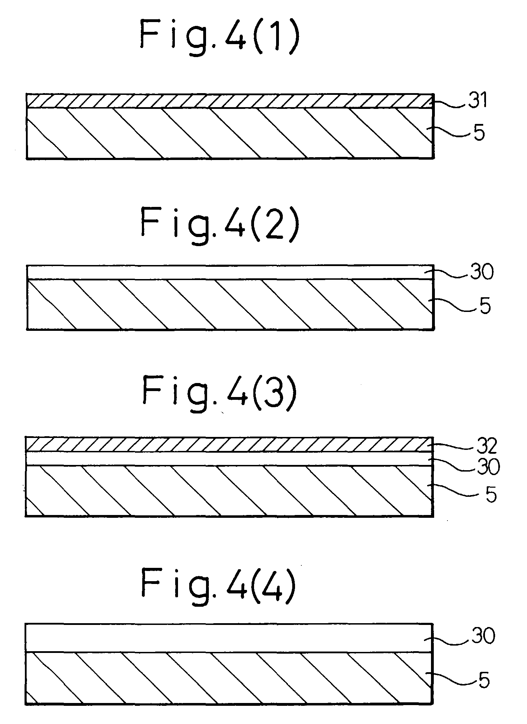

Referring to Figs. 4(1) to 4(4), the growth process of a silicon crystal thin film according to this example will be described below.

(1) The first laser beam 1 is irradiated to the target 8 (Fig. 1) to effect laser ablation to form an amorphous a-Si deposited layer 31 on the surface of the substrate 5. The deposited layer had a thickness of about 50 nm, which is determined as: the thickness = 1.7 nm/min × 30 min = about 50 nm. Note that, for clarity, the substrate is shown in Figs. 4(1) to 4(4) in a position upside down with respect to that shown in Fig. 1.

(2) The second laser beam 12 is then irradiated onto the amorphous Si deposited layer 31 to melt-recrystallize the layer 31 to form Si polycrystalline layer 30.

(3) The first laser beam 1 is irradiated to the target 8 to effect laser ablation to form an amorphous Si 32 deposit (50 nm thick).

(4) The second laser beam 2 is irradiated to the amorphous Si deposited layer to effect melt-recrystallization. This recrystallization is effected as an epitaxial growth on the Si crystal layer 30, so that the Si crystal layer grows to have a double thickness.

Thereafter, the deposition and melt-recrystallization cycle is repeated at necessary times to provide a Si crystal thin film having a desired thickness.

As described above, the present invention uses a selected value of the thickness of an amorphous deposited layer to be subjected to melt-recrystallization, which enables the use of a relatively small irradiation energy which does not ablate the deposited layer to achieve complete recrystallization over the entire thickness of the deposited layer without causing occurrence of cracks and other defects, thereby finally providing a crystal thin film having a desired thickness.

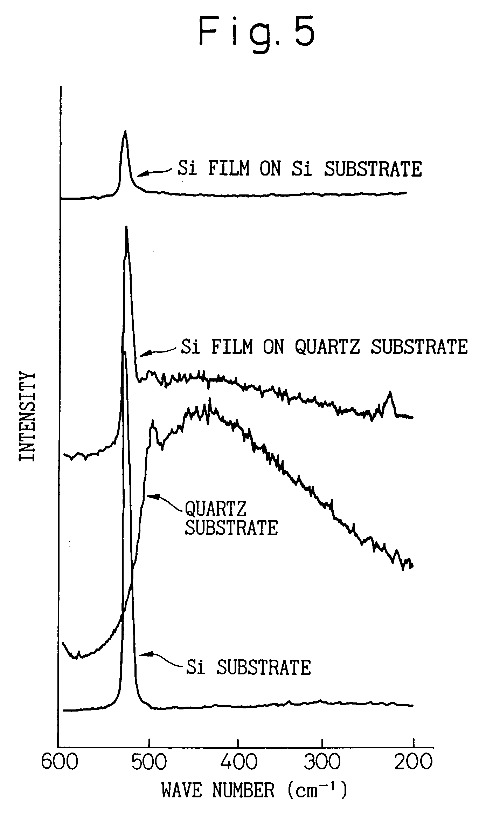

Si crystal thin film was tested for the crystal quality by RHEED and Raman scattering. Figure 5 shows the result obtained from Raman scattering, for Si thin film on a silicon substrate and a quartz substrate, together-with the results for these substrates for comparison. It can be seen from the shown results that silicon crystal films having good crystal quality were formed both on the silicon substrate and the quartz substrate.

The conventional CVD process could not be free from the problems of optical degradation and a widened band gap. The crystal thin film obtained by the present invention is free from the above-mentioned problems due to inclusion of hydrogen because the film forming process contains no hydrogen sources. Because of no inclusion of hydrogen, the deposited Si layer is also crystallized easily.

Example 2

Although Example 1 used separate laser beams for laser ablation and melt-recrystallization, a single laser beam may be divided for these two applications.

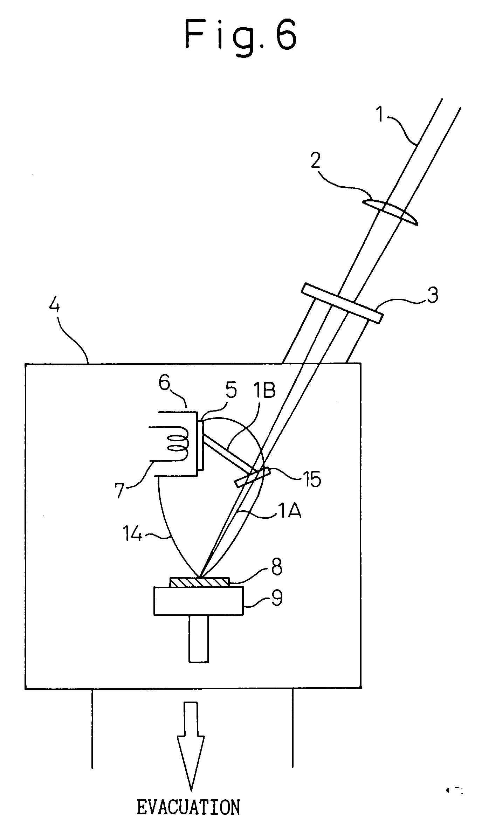

Figure 6 shows an apparatus for forming a crystal thin film by laser ablation according to an embodiment of the present invention, particularly for dividing a single laser beam.

The apparatus for forming a crystal thin film shown in Fig. 6 does not have the second laser beam 12 for melt-recrystallization and the introduction port 13 therefor but has a half mirror or a beam splitter 15 for dividing a laser beam 1 for laser ablation. The RHEED 10, 11 are optional and omitted from Fig. 6.

On the way from a laser beam introduction port 3 to a target 8, a laser beam 1 for laser ablation is divided or split by the half mirror or beam splitter 15 to a first split laser beam 1A for laser ablation and a second split laser beam 1B for melt-recrystallization.

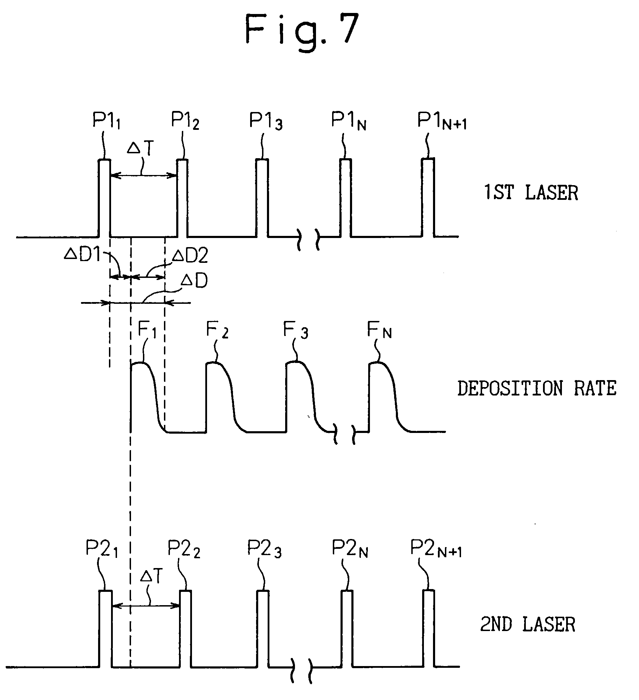

These two branched laser beams originate from one laser beam, and therefore, are irradiated to the target and the deposited layer on the substrate at the same time. Figure 7 shows a time chart for deposition and melt-recrystallization in this case. The ablating laser pulses $P1_1$, $P1_2$, $P1_3$, ... $P1_N$ are irradiated synchronously with the melt-recrystallizing laser pulses $P2_1$, $P2_2$, $P2_3$, ... $P2_N$. The deposition rates of the deposited layers by the ablating laser pulses $P1_1$, $P1_2$, $P1_3$, ... $P1_N$ have peaks $F_1$, $F_2$, $F_3$, ... $F_N$ as shown in Fig. 7.

It should be noted here that, as aforementioned in Example 1, it takes a time $\Delta D1$ depending on the distance between a target and a substrate for an emitted substance from the target to reach the substrate and the sum of $\Delta D1$ and a time $\Delta D2$ necessary for deposition to proceed on the substrate is a deposition time lag $\Delta D\ (= \Delta D1 + \Delta D2)$. To ensure that melt-recrystallization is effected after completion of the formation of a deposited layer or deposited layers to be subjected to melt-recrystallization in one deposition and melt-recrystallization cycle, the oscillation time difference $\Delta T$ between an ablating pulse and a melt-recrystallizing pulse must be greater than the deposition time lag $\Delta D$.

Therefore, in this Example, if the laser frequency is selected so that the oscillation period or the oscillation time difference $\Delta T$ is greater than the deposition time lag $\Delta D$, a next melt-recrystallizing pulse can be irradiated to a deposited layer after completion of deposition by an ablating pulse for one cycle. Specifically, as shown in Fig. 7, a deposited layer $F_1$ (denoted by the same reference symbol as the corresponding deposition rate peak) deposited by the ablating laser pulse $P1_1$ is irradiated by the next melt-recrystallizing pulse $P2_2$. In this sequential manner, a deposited layer $F_N$ deposited by an ablating pulse $P1_N$ is irradiated and melt-recrystallized by a melt-recrystallizing pulse $P2_{N+1}$.

In general, referring to Fig. 6, the melt-recrystallizing laser beam 1B should have a power of irradiation energy smaller than that of the ablating laser beam 1A. This power adjustment can be performed by the adjustment of the split ratio of the beam splitter or half mirror 15 and/or by disposing an extinction filter between the splitter and the substrate, etc.

An embodiment according to this example reduces the production cost because of the use of a single laser source, which is split by a light splitting means such as a half mirror or beam splitter, into two split laser beams, one of which is used as an ablating laser beam to be irradiated to a target and the other is used as a melt-recrystallizing laser beam to be irradiated to a deposited layer on a substrate.

Example 3

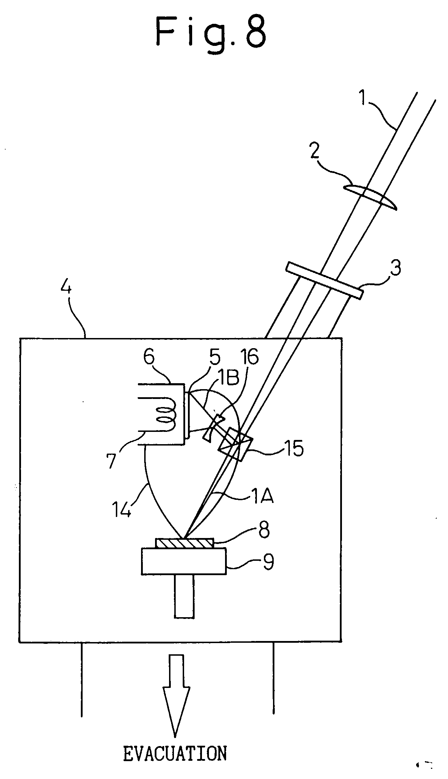

Figure 8 shows another apparatus for forming a crystal thin film by laser ablation according to an embodiment of the present invention, particularly for dividing or splitting a single laser beam.

The apparatus shown in Fig. 8 has the same arrangement as shown in Fig. 6 except for an additional concave lens 16.

On the way from a laser beam introduction port 3 to a target 8, a laser beam 1 for laser ablation is divided or split by the half mirror or beam splitter 15 to a first split laser beam 1A for laser ablation and a second split laser beam 1B for melt-recrystallization. The ablating laser beam 1A is directly irradiated to a target 8. On the other hand, the melt-recrystallizing laser beam 1B is radially broadened by the concave lens 16 to have an energy density lower than that it initially possessed and is then irradiated onto a deposited layer on the substrate 5. To provide an optimum energy density for melt-recrystallization, an extinction filter (not shown) may be additionally provided between the concave lens 16 and the substrate 5.

In this example, the substrate 5 was rotated at a speed of 3 rpm to provide a uniform energy density distribution over the substrate 5. An excimer laser (1 Hz, 30 J/cm$^2$) was used and the energy density on the substrate was 0.5 J/cm$^2$. A vacuum of $5 \times 10^{-7}$ Torr was maintained in the vacuum chamber 4 and the distance between the substrate 5 and the target 8 was 40 mm. The substrate was a quartz substrate and was held at room temperature. The delay time $\Delta D1$ from the irradiation of the ablating laser beam 1A to the actual beginning of deposition on the substrate was 0.1 sec. Deposition actually began a delay time $\Delta D1$ of 0.1 sec after the ablating laser beam 1A irradiated the target 8. The thus obtained Si crystal thin film was subjected to the same examination for the crystal quality as in Example 1, and the result showed that as good a crystal quality was obtained as in Example 1.

As herein described above, the present invention uses a selected value of the thickness of an amorphous deposited layer to be subjected to melt-recrystallization, which enables the use of a relatively small irradiation energy which does not ablate the deposited layer to achieve complete recrystallization over the entire thickness of the deposited layer without causing occurrence of cracks and other defects, thereby finally providing a crystal thin film having a desired thickness.

A process of forming a crystal thin film by laser ablation, comprising the step of: either performing plural times a deposition and recrystallization cycle composed of the phase of irradiating a laser beam to a target to cause emission of a material from the target and deposition of the emitted material on a substrate and the phase of irradiating a laser beam to a deposited layer formed by said deposition to cause melting and recrystallization of the deposited layer, thereby forming a crystal thin film having a selected thickness; or performing at least once a deposition and recrystallization cycle composed of the phase of irradiating a laser beam to a target to cause emission of a material from the target and deposition of the emitted material on a substrate and the phase of irradiating a laser beam to a deposited layer formed by said deposition to cause melting and recrystallization of the deposited layer; and then performing said phase of deposition alone to cause an epitaxial growth on a crystal layer formed by said melting and recrystallization, thereby forming a crystal thin film having a selected thickness.

The present invention uses a selected value of the thickness of an amorphous deposited layer to be subjected to melt-recrystallization, which enables the use of a relatively small irradiation energy which does not ablate the deposited layer to achieve complete recrystallization over the entire thickness of the deposited layer without causing occurrence of cracks and other defects, thereby finally providing a crystal thin film having a desired thickness.

## Claims

1. A process of forming a crystal thin film by laser ablation, comprising the step of:

    performing plural times a deposition and recrystallization cycle composed of the phase of irradiating a laser beam to a target to cause emission of a material from the target and deposition of the emitted material on a substrate and the phase of irradiating a laser beam to a deposited layer formed by said deposition to cause melting and recrystallization of the deposited layer, thereby forming a crystal thin film having a selected thickness.

2. A process of forming a crystal thin film by laser ablation, comprising the steps of:

    performing at least once a deposition and recrystallization cycle composed of the phase of irradiating a laser beam to a target to cause emission of a material from the target and deposition of the emitted material on a substrate and the phase of irradiating a laser beam to a deposited layer formed by said deposition to cause melting and recrystallization of the deposited layer; and then performing said phase of deposition alone to cause an epitaxial growth on a crystal layer formed by said melting and recrystallization, thereby forming a crystal thin film having a selected thickness.

3. A process of forming a crystal thin film by laser ablation according to claim 1, further comprising the steps of:

    splitting a laser beam using a light splitting means to form two split laser beams; irradiating one of the two split laser beams onto said target; and irradiating the other of the two split beams onto said deposited layer.

4. A process of forming a crystal thin film by laser ablation according to claim 2, further comprising the steps of:

splitting a laser beam using a light splitting means to form two split laser beams;
irradiating one of the two split laser beams onto said target; and
irradiating the other of the two split beams onto said deposited layer.

# Fig.1

EVACUATION

# Fig. 2

# Fig. 3(a)

1ST LASER

2ND LASER

# Fig. 3(b)

1ST LASER

2ND LASER

# Fig.4(1)

31
5

# Fig.4(2)

30
5

# Fig.4(3)

32
30
5

# Fig.4(4)

30
5

# Fig. 5

# Fig. 6

EVACUATION

# Fig.7

# Fig.8

EVACUATION

**European Patent Office**

**EUROPEAN SEARCH REPORT**

Application Number

EP 97 11 2059

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | HUANG F ET AL: "The effect of in situ laser annealing on laser ablation deposited garnet films" MATERIALS LETTERS, DEC. 1994, NETHERLANDS, vol. 21, no. 5-6, ISSN 0167-577X, pages 365-369, XP002045434 | 1,3 | C30B13/24 |
| A | * page 365, right-hand column, line 7 - page 366, right-hand column, line 2 * | 2,4 | |
| A | GB 2 250 751 A (KAWASAKI HEAVY IND LTD) 17 June 1992 * page 6, line 17 - page 7, line 2 * | 1-4 | |
| A | US 4 701 592 A (CHEUNG JEFFREY T) 20 October 1987 * column 7, line 44 - column 8, line 16 * | 1-4 | |
| A | PATENT ABSTRACTS OF JAPAN vol. 015, no. 340 (E-1105), 28 August 1991 & JP 03 129724 A (FUJITSU LTD), 3 June 1991, * abstract * | 1-4 | |
| A | PATENT ABSTRACTS OF JAPAN vol. 008, no. 193 (C-241), 5 September 1984 & JP 59 083993 A (NIPPON DENKI KK), 15 May 1984, * abstract * | 1-4 | |

TECHNICAL FIELDS SEARCHED (Int.Cl.6)

C23C
C30B

The present search report has been drawn up for all claims

| Place of search | Date of completion of the search | Examiner |
|---|---|---|
| THE HAGUE | 3 November 1997 | Ekhult, H |

EPO FORM 1503 03.82 (P04C01)